# EUROPEAN PATENT APPLICATION

(11) **EP 1 187 228 A1**
(43) Date of publication of application: **13.03.2002**
(21) Application number: 01904371.0
(22) Date of filing: 09.02.2001
(51) Int. Cl.: H01L 33/00

(54) **LIGHT SOURCE**

(30) Priority: 09.02.2000 JP 2000032116; 15.11.2000 JP 2000348383
(71) Applicant: Nippon Leiz Corporation, Tama-shi, Tokyo 206-0025 (JP)
(72) Inventor: FUJIWARA, Tsubasa, Nippon Leiz Corporation, Tama-shi, Tokyo 206-0025 (JP); NAKANO, Akio, Nippon Leiz Corporation, Tama-shi, Tokyo 206-0025 (JP)
(74) Representative: Greenwood, John David
(86) International application number: PCT/JP01/00930
(87) International publication number: WO 01/59851

(57) **Abstract**

The object of the invention is to provide light equipment which effectively utilizes the light emanating from a semiconductor luminous element and which can acquire clear and high-luminance light emission without a color dapple. The light equipment is configured as follows. Transparent resin in which wavelength converting material is mixed is provided on the reflecting surface of base material such as a case, a board and a lead frame, a transparent semiconductor luminous element is mounted, bonded and fixed on the transparent resin, the wavelength of light emitted from the back surface of the semiconductor luminous element is converted by the wavelength converting material, the converted light is reflected on the reflecting surface, the reflected light is mixed with light emitted from the surface of the semiconductor luminous element and the mixed light is radiated.

## Description

### BACKGROUND OF THE INVENTION AND RELATED ART STATEMENT

The present invention relates to light equipment used for a light source of a liquid crystal display and others. Particularly, the present invention relates to light equipment wherein clear and high-luminance emission without a color dapple can be acquired effectively utilizing the light emanating from a semiconductor luminous element for a long term.

A light emitting diode which is a semiconductor luminous element is small-sized. Clear luminescent color can be efficiently acquired without anxiety that a light bulb is burnt-out. The light emitting diode has a characteristic that it is also excellent in a drive characteristic and is also strong in vibration and repetitive operation by switching for turning on and turning off. Therefore, the light emitting diode is utilized for a light source of various indicators and a liquid crystal display.

Heretofore, for light equipment for indicative full color on a liquid crystal display and others, a light emitting diode (LED) lamp is known. The LED lamp has semiconductor luminous elements each luminescent color of which is red, blue and green, that is, three semiconductor luminous elements of so-called RBG. The three semiconductor luminous elements are provided to a board as one unit.

Full color light equipment is also known. The full color light equipment has three semiconductor luminous elements each luminescent color of which is red, blue and green are provided to one lead frame.

A light emitting diode used for this type of light equipment has an excellent monochromatic peak wavelength. Therefore, in case light equipment that emits white light is composed utilizing light emitting diodes that respectively emit red light, green light and blue light for example, the light emitting diodes that respectively emit each color light are required to be arranged closely to diffuse and mix each color light.

Concretely, to acquire light equipment that emits white light, three types of red, green and blue light emitting diodes or two types of bluish green and yellow light emitting diodes are required. That is, to acquire light equipment that emits white light, light emitting diodes of plural types different in luminescent color are required to be used.

In addition, a semiconductor light emitting diode chip has non-uniformity in a tone and luminance. In case plural light emitting diodes are made of different material, the driving power of each light emitting diode chip is different and a power source is required to be individually secured.

Therefore, to acquire a white light emanating, current and others supplied every light emitting diode are required to be adjusted. There is a problem that a used light emitting diode is different in a temperature characteristic and aging and a tone also changes. Further, in case emission from each light emitting diode chip is not mixed uniformly, the light emanating may include irregular color and desired white emission may not be acquired.

Particularly, in light equipment wherein three types of semiconductor luminous elements of red, blue and green luminescent colors are provided on a board and are used as one unit, there is a problem the light equipment is large-sized. In addition, as there is distance between the semiconductor luminous elements, there is a problem that it is difficult to acquire mixed color, mixed color has non-uniformity and face color of the one unit light equipment is coarse.

In light equipment in which three types of semiconductor luminous elements of red, blue and green luminescent colors are provided to one lead frame and others, to acquire white luminescent color, charge is required to be supplied to all semiconductor luminous elements including red, blue and green. Therefore, there are a problem of large power consumption and energy conservation and a problem of space required by a battery in a portable (mobile) type.

Then, for light equipment in which the above-mentioned problems are solved, light equipment disclosed in Japanese published unexamined patent applications No. Hei 7-99345, No. Hei 10-190066 and No. Hei 10-242513 is known.

In the light equipment disclosed in Japanese published unexamined patent application No. Hei 7-99345, an LED chip is mounted at the bottom of a cup. Resin (a color converting member) including a fluorescent matter (or a filter matter for partially absorbing the emission wavelength of the luminous chip) for converting the emission wavelength of the LED chip to another wavelength is filled inside the cup. Further, resin is provided so that the resin encircles the above-mentioned resin.

The light equipment disclosed in Japanese published unexamined patent application No. Hei 10-190066 is provided with an LED chip fixed on a board by a die bonding member and a color converting member provided on the LED chip. The color converting member includes a fluorescent matter that absorbs at least a part of light emission from the LED chip, converts the wavelength and emits.

For the light equipment disclosed in Japanese published unexamined patent application No. Hei 10-242513, a pair of mount-leads is provided with the light equipment. Front edge of one of mount-lead is in the form of a cup. An LED chip made of a gallium nitride semiconductor is arranged in the cup. The LED chip is electrically connected via an inner lead with the other mount-lead. Transparent resin including a fluorescent matter is filled in the cup. In another light equipment, a gallium nitride semiconductor chip is arranged in the body of the equipment and transparent resin including a fluorescent matter is filled in the body.

The light equipment disclosed in the above-mentioned each patent application acquires another luminescent color from one type of luminescent color of a semiconductor luminous element itself. Concretely, for a light emitting diode that converts the wavelength of light emitted from an LED chip, white light emission is acquired by mixing light emission from a blue light emitting diode and light emission from fluorophor that absorbs the above-mentioned light emission and emits yellow light.

In the light equipment disclosed in the above-mentioned any patent application, a color converting member is provided on an LED chip. Therefore, in case white light is acquired, the dispersed light of blue light radiated above the LED chip from the LED chip itself and yellow light converted by the color converting member provided on the LED chip looks to be white light for a human eye.

To acquire clear and high-luminance white light, the non-uniformity and the distribution of blue light and yellow light are required to be uniform and fixed. However, in the configuration disclosed in the above-mentioned each patent application, blue light is shielded by the color converting member on the LED chip. Luminance of the light equipment is determined by the composed light quantity of light acquired by converting the color by the color converting member and blue light radiated by the LED chip itself. Therefore, there is a problem that the non-uniformity and the distribution of the color converting member are required to be uniform and luminance is not satisfactory.

Apart from the color converting member including a fluorescent matter for converting the wavelength of light from the LED chip, a die bonding member (a mounting member) for fixing a luminous chip or an LED chip is required.

Further, the configuration disclosed in Japanese published unexamined patent application No. Hei 7-99345 has a problem that as a semiconductor luminous element is put in wavelength converting material, it is difficult to acquire mixed color.

Also, in the configuration disclosed in Japanese published unexamined patent application No. Hei 10-242513, a gallium nitride semiconductor is arranged in a cup or the body of equipment. A fluorescent matter such as wavelength converting material is filled on the semiconductor and on the four sides. Hereby, the fluorescent matter is uniformly dispersed in transparent resin. In addition, there is a problem that it is difficult to control dispersed quantity or the thickness on the four sides and dispersed quantity or the thickness on the surface. In addition to the configuration disclosed in the above-mentioned each patent application, there is also known another configuration. In the configuration, a blue light emitting semiconductor luminous element is enveloped in the shape of a lamp by whole resin including wavelength converting material. Hereby, white luminescent color can be acquired by only a semiconductor luminous element lamp by converting the wavelength of light emitted from the semiconductor luminous element to another wavelength.

However, in the above-mentioned configuration, the quantity of used wavelength converting material is increased and the configuration has a problem of the stability of the non-uniformity and the distribution of the wavelength converting material.

As described above, light emission acquired in case the above-mentioned conventional type light equipment is not enough to use for a light source for a liquid crystal display and others. Therefore, high-luminance light emission (particularly, white light emission) in use environment for a longer term has been desired.

The invention is made to solve the above-mentioned problems. The invention has an object of effectively utilizing the light emanating from a semiconductor luminous element and acquiring clear and high-luminance light emission without a color dapple. The invention also has an object of providing light equipment that enables acquiring high-luminance light emission in use environment for a long term, compared with a conventional type.

### SUMMARY OF THE INVENTION

Referring to the drawings corresponding to embodiments, the configuration of the invention to achieve the objects will be described below. That is, light equipments 1A to 1L according to the invention are provided on the reflecting surface of base material (a board 11 having reflectivity, a lead frame 21, and, a pattern having reflectivity and an electric wiring pattern in a case 7), are provided with transparent resin 3 in which wavelength converting material is mixed and a transparent semiconductor luminous element 4 provided on the transparent resin 3. In the light equipment, the wavelength of light emitted from the back surface 4a of the semiconductor luminous element 4 is converted by the wavelength converting material, the light the wavelength of which is converted is reflected on the reflecting surface, the reflected light and light directly emitted from the front surface 4b of the semiconductor luminous element 4 are mixed and the mixed light is radiated from the front surface 4b of the semiconductor luminous element 4.

According to these light equipments, light radiated downward from the back surface 4a of the semiconductor luminous element 4 is reflected upward again as light the wavelength of which is converted by the wavelength converting material of the transparent resin 3. Hereby, the reflected light and direct radiated light emanating from the semiconductor luminous element 4 are completed mixed and uniform light can be radiated upward from the front surface 4b of the semiconductor luminous element 4.

Conductive material may be further mixed in the transparent resin 3 in addition to the wavelength converting material. When the semiconductor luminous element 4 is bonded and fixed on the transparent resin 3, static electricity can be prevented from being electrified in the semiconductor luminous element 4 itself.

The light equipment according to a third aspect is characterized in that the transparent resin 3 is formed in larger area than the area of the semiconductor luminous element 4 on base material and the semiconductor luminous element 4 is bonded and fixed on the transparent resin 3 on the base material.

According to the light equipment, light radiated downward from the back surface 4a of the semiconductor luminous element 4 is reflected upward again as light the wavelength of which is converted by the wavelength converting material of the transparent resin 3. Further, light radiated from the four sides 4e of the semiconductor luminous element 4 goes downward. And the radiated light is reflected again substantially upward as light the wavelength of which is converted by the wavelength converting material of the transparent resin 3 provided in larger area than the area of the semiconductor luminous element 4. The reflected light and direct radiated light emanating from the semiconductor luminous element 4 are completed mixed. Hereby, uniform light can be radiated upward. The transparent resin 3 is provided in larger area than the area of the semiconductor luminous element 4. Hereby, when the wavelength converting material mixed in the transparent resin 3 is applied or printed at fixed and uniform thickness, a mixed whole tone can be controlled not by the thickness but by the area. In addition, the transparent resin 3 also functions as an adhesive and can fix the semiconductor luminous element.

Light equipment according to a fourth aspect is characterized in that a concave portion (22, 25) is provided in base material, transparent resin 3 is filled in the concave portion (22, 25) and a semiconductor luminous element 4 is bonded and fixed on the transparent resin 3 filled in the concave portion (22, 25).

According to the light equipment, high-luminance light emission can be acquired, compared with a conventional type case that transparent resin in which fluorescent material is mixed is provided on a semiconductor luminous element. In addition, the semiconductor luminous element 4 is bonded and fixed by the transparent resin 3 filled in the concave portion (22, 25). Therefore, the transparent resin 3 also functions as an adhesive, more light the wavelength of which is converted is returned to the semiconductor luminous element 4 again and convergency can be enhanced.

Light equipment according to a fifth aspect is characterized in that the aperture area of a concave portion 22 is smaller than the area of the back surface 4a of a semiconductor luminous element 4.

According to the light equipment, direct light from the semiconductor luminous element 4 and light the wavelength of which is converted can be efficiently outgoing outside.

Light equipment according to a sixth aspect is characterized in that the inner wall of a concave portion 25 is opposite to the side 4e of a semiconductor luminous element 4 and is formed into an inclined face 23 expanded from the bottom 25a to the aperture.

According to the light equipment, light radiated downward from the back surface 4a of the semiconductor luminous element 4 is reflected upward again as light the wavelength of which is converted by the wavelength converting material of transparent resin 3. Further, light is radiated from the four sides 4e of the semiconductor luminous element 4 and goes sideway and downward. The radiated light is securely reflected substantially upward again as light the wavelength of which is converted by the wavelength converting material of the transparent resin 3 formed on the inclined face 23 in each position corresponding to the four sides 4e of the semiconductor luminous element 4. The reflected light and direct radiated light outgoing from the semiconductor luminous element 4 are completed mixed. Hereby, uniform light can be radiated upward.

Light equipment according to a seventh aspect is characterized in that an angle between the inclined face 23 of a concave portion 25 and the bottom 25a of the concave portion 25 is larger than 0° and is 45° or less.

According to the light equipment, a beam that goes sideway out of light emanating from the directions of the four sides 4e of the semiconductor luminous element 4 is reflected substantially right over. A beam that goes slightly diagonally downward is reflected upward on the substantially inside of the semiconductor luminous element 4. A beam that goes diagonally upward is reflected upward on the substantially outside of the semiconductor luminous element 4. Therefore, the light emanating from the directions of the four sides 4e of the semiconductor luminous element 4 can be effectively utilized.

The form of the aperture of a concave portion 22 of the light equipment may be also rectangular or circular depending upon the form of the semiconductor luminous element 4. Hereby, light from the back surface 4a of the semiconductor luminous element 4 can be effectively projected onto the concave portion 22 in full and the machining is also easy.

In case the concave portion 22 is machined by etching, a laser beam or electric discharge, it can be precisely formed as an aperture which is minute and satisfactory in reflection efficiency. Therefore, the concave portion 22 which is smaller than the size of the back surface 4a of the semiconductor luminous element 4 can be provided.

The semiconductor luminous element 4 may be also bonded and fixed on the transparent resin 3 via a transparent adhesive 9. It is desirable that the semiconductor luminous element 4 is used, a semiconductor luminous element wherein an active layer is arranged on a transparent board and a transparent electrode is provided on the active layer.

For base material used for the light equipment, any of a board 11 such as a ceramic board, a liquid crystal polymer resin board and a glass fiber epoxy resin board, a lead frame 21 and a case 7 having reflectivity can be selectively used. Hereby, independent of a place and material, a semiconductor luminous element is bonded and fixed anywhere and arbitrary mixed light such as white light can be acquired.

For the semiconductor luminous element 4, any of InGaAlP, InGaAlN, InGaN and GaN can be selectively used. Hereby, desired mixed light can be acquired depending upon combination with wavelength converting material mixed in the transparent resin 3.

In the light equipment according to the invention, if wavelength converting material mixed in the transparent resin 3 is evenly distributed without being dispersed when it is viewed as a two-dimensional face, the light emanating from the semiconductor luminous element can be further effectively utilized, compared with the conventional type configuration that the transparent resin in which fluorescent material is mixed is filled on the semiconductor luminous element at random.

### BRIEF DESCRIPTION OF THE DRAWINGS

FIG. 1 is a general drawing showing a first embodiment of light equipment according to the invention;
FIG. 2 is a side sectional view of FIG. 1;
FIG. 3 shows one configuration of a semiconductor luminous element;
FIG. 4 shows the result of the comparison of measured luminous intensity in conventional type configuration that transparent resin in which fluorescent material is mixed is provided on a semiconductor luminous element and in configuration according to the invention (light equipment equivalent to the first embodiment) that transparent resin in which fluorescent material is mixed is bonded and fixed under a semiconductor luminous element or a semiconductor luminous element is mounted (bonded) on transparent resin in which fluorescent material is mixed;
FIG. 5 is a general drawing showing a second embodiment of the light equipment according to the invention;
FIG. 6 is a partial sectional view showing a third embodiment of the light equipment according to the invention;
FIG. 7 is a partial sectional view showing a fourth embodiment of the light equipment according to the invention;
FIG. 8 is a partial sectional view showing a transformed example of the light equipment equivalent to the fourth embodiment;
FIG. 9 is a general drawing showing a fifth embodiment of the light equipment according to the invention;
FIG. 10 is a partial sectional view showing a sixth embodiment of the light equipment according to the invention;
FIG. 11 is a partial sectional view showing a seventh embodiment of the light equipment according to the invention;
FIG. 12 is a partial sectional view showing a transformed example of the light equipment according to the invention;
FIG. 13 is a partial sectional view showing an eighth embodiment of the light equipment according to the invention;
FIGs. 14(a) to 14(c) are front views showing each concave portion provided to a lead frame or a board formed by injection molding in the light equipment equivalent to the eighth embodiment;
FIG. 15 is a perspective view showing a ninth embodiment of the light equipment according to the invention;
FIG. 16 is a partial side sectional view showing the light equipment equivalent to the ninth embodiment;
FIG. 17 is a partial sectional view showing a tenth embodiment of the light equipment according to the invention and is a side sectional view showing the light equipment where an inclined face is provided to a lead frame, a board or a case;
FIG. 18 shows the locus of light reflected on a reflecting surface after the wavelength is converted by wavelength converting material of transparent resin in the configuration of the tenth embodiment of the light equipment according to the invention;
FIG. 19 is a partial side sectional view showing an eleventh embodiment of the light equipment according to the invention;
FIG. 20 is a partial side sectional view showing a transformed example of the light equipment equivalent to the eleventh embodiment;
FIG. 21 is a partial side sectional view showing a twelfth embodiment of the light equipment according to the invention; and
FIG. 22 is a partial side sectional view showing a transformed example of the light equipment equivalent to the twelfth embodiment.

### DETAILED DESCRIPTION OF THE PREFERRED EMBODIMENTS

### EMBODIMENT 1

Referring to the attached drawings, the invention will be described more detailedly below.

Light equipment according to the invention described below is light equipment using a transparent InGaAlP, InGaAlN, InGaN or GaN semiconductor luminous element. Example, the semiconductor luminous element is mounted on a reflective lead frame, a reflective board or a reflective pattern and a reflective electric wiring pattern in a case intermediating example via transparent resin in which wavelength converting material is mixed.

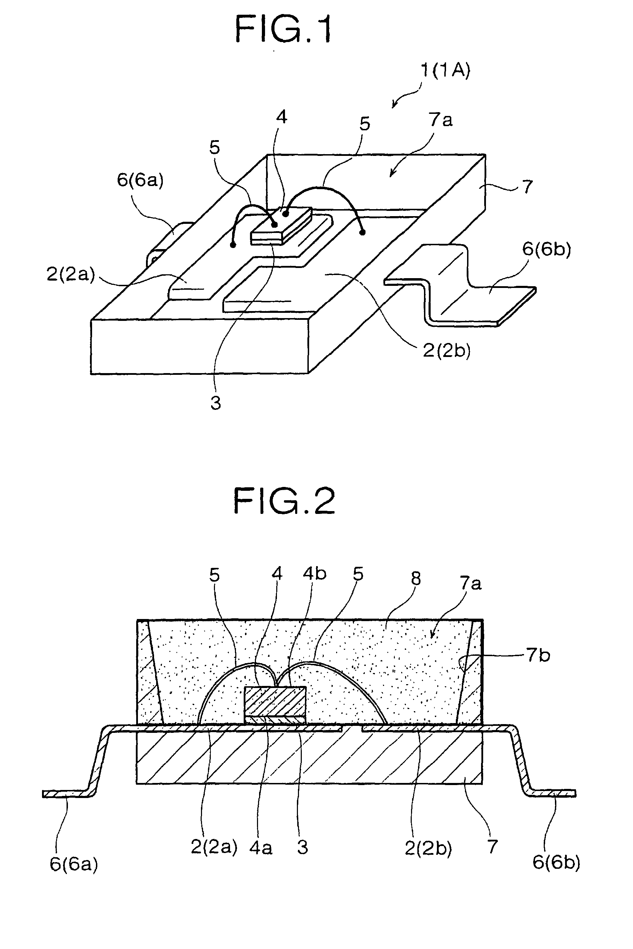

FIG. 1 is a general drawing showing a first embodiment of the light equipment according to the invention. FIG. 2 is a side sectional view of FIG. 1.

The light equipment 1 (1A) equivalent to the first embodiment shown in FIGs. 1 and 2 is formed by injection moulding or transfer moulding. This light equipment 1A is substantially composed of a pattern 2 (2a, 2b), transparent resin 3, a semiconductor luminous element 4, bonding wire (hereinafter called wire) 5, a lead terminal 6 (6a, 6b) and a molding case (hereinafter called a case) 7. The pattern 2 in this embodiment also includes an electric wiring pattern.

The pattern 2 (2a, 2b) is formed on a lead frame having a predetermined pattern form and made of phosphor bronze and others. The case 7 made of resin is inserted into the lead frame.

The transparent resin 3 is acquired by mixing wavelength converting material such as inorganic fluorescent pigment and organic fluorescent dye in transparent and colorless epoxy resin and others. In case fluorescent material (YAG) is mixed in epoxy resin for example, the weight ratio of the epoxy resin and the fluorescent material is approximately 1 : 3 to 1 : 4. This transparent resin 3 can be formed on the pattern 2 as a printed pattern by applying on the pattern 2 or by printing fluorescent material mixed ink and others.

The transparent resin 3 is provided between the pattern 2 exposed at the bottom in a concave portion 7a of the case 7 and the back surface 4a (the surface without an electrode) of the semiconductor luminous element 4. In an example shown in FIGs. 1 and 2, the transparent resin 3 is provided in area substantially similar to the back surface 4a of the semiconductor luminous element 4. This transparent resin 3 also functions as an adhesive cement for sticking the semiconductor luminous element 4 on the pattern 2.

Further, in case a semiconductor luminous element that emits blue light is used for the semiconductor luminous element 4, the transparent resin 3 is formed by resin in which wavelength converting material including orange fluorescent pigment or orange fluorescent dye such as Yttrium-Aluminum-Garnet (YAG) including CaSiO₃: Pb, Mn and (Y, Gd)₃(Al, Ga)₅O₁₂ is mixed. Hereby, yellow light is acquired by projecting blue light from the semiconductor luminous element 4 onto the resin in which wavelength converting material including orange fluorescent pigment or orange fluorescent dye is mixed. When yellow light acquired by color conversion by the wavelength converting material of the transparent resin 3 and blue light radiated by the semiconductor luminous element 4 itself are mixed, light radiated upward from the front surface 4b of the semiconductor luminous element 4 itself becomes white light.

Also, in case a semiconductor luminous element that emits green light for example is used for the semiconductor luminous element 4, the transparent resin 3 is formed by resin in which wavelength converting material including red fluorescent pigment or red fluorescent dye is mixed. Hereby, yellow light is acquired by projecting green light from the semiconductor luminous element 4 onto the resin in which the wavelength converting material including red fluorescent pigment or red fluorescent dye is mixed.

Further, in case the transparent resin 3 is formed by resin in which wavelength converting material including green fluorescent pigment or green fluorescent dye is mixed when a semiconductor luminous element that emits blue light is used for the semiconductor luminous element 4, bluish green light is acquired by projecting blue light from the semiconductor luminous element 4 onto the resin in which the wavelength converting material including green fluorescent pigment or green fluorescent dye is mixed.

The transparent resin 3 may be such resin that acquired by mixing wavelength converting material including inorganic fluorescent pigment or organic fluorescent dye and others and conductive material in transparent and colorless epoxy resin.

The conductive material in this case is mixed at limit at which filler such as a silver particle does not have a bad effect upon fluorescent material. The conductive material has a high resistance value at degree at which the positive electrode and the negative electrode of the semiconductor luminous element 4 itself are not short-circuited at low charge.

Even if higher potential static electricity than applied voltage and others are electrified in the whole semiconductor luminous element 4, the static electricity and others are made to flow to the ground by adding conductive material to the semiconductor luminous element 4 the charge of which is high by minute quantity. Hereby, the InGaAlP, InGaAlN, InGaN or GaN semiconductor luminous element 4 itself which is weak in static electricity is protected from static electricity and others.

Concretely, the volume resistivity of conductive material in resin in which fluorescent material is mixed is approximately 150 to 300 kΩ. The forward resistance of the semiconductor luminous element 4 is 165 Ω and the peak inverse resistance is 2.5 MΩ. Hereby, the resistance of the conductive material is resistance at degree at which current does not leak out into the semiconductor luminous element 4 and has a lower value than the peak inverse resistance. Therefore, current is made to flow to the ground and static electricity can be prevented from being electrified in the semiconductor luminous element 4 itself.

The semiconductor luminous element 4 is a luminous element formed by an InGaAlP, InGaAlN, InGaN or GaN semiconductor chip having double heterostructure with active layers on an N-type board in the center and is manufactured by organometal vapor phase epitaxy.

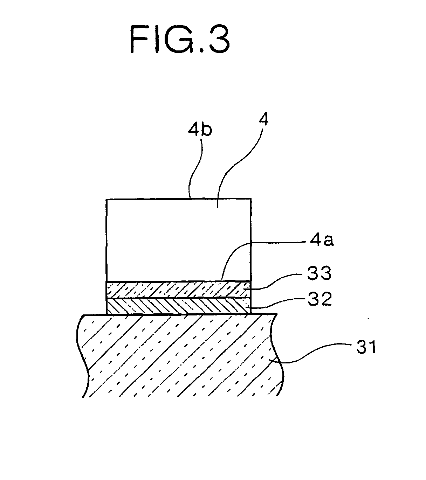

The board of the semiconductor luminous element 4 itself is a transparent board 31 made of Al₂O₃ or indium phosphide sapphire. As shown in FIG. 3, an active layer 32 is provided on the transparent board 31. A transparent electrode 33 is formed on the active layer 32. The electrode provided to the semiconductor luminous element 4 is produced by generating a conductive transparent electrode made of In₂O₃, SnO₂ or ITO by sputtering, vacuum evaporation or chemical vapor deposition.

The semiconductor luminous element 4 has an anode and a cathode on one surface (the upper surface shown in FIG. 2: the front surface 4b). The other surface (the lower surface shown in FIG. 2: the back surface 4a) without an electrode of the semiconductor luminous element 4 is mounted and fixed on the transparent resin 3. The anode and the cathode of the semiconductor luminous element 4 are respectively bonded to the patterns 2a and 2b by wire 5.

The wire 5 is made of conductive wire such as gold wire. This wire 5 electrically connects the anode of the semiconductor luminous element 4 and the pattern 2a, and the cathode and the pattern 2b respectively owing to a bonder.

The lead terminal 6 (6a, 6b) is formed by directly pulling a conductive and elastic lead frame made of a copper alloy such as phosphor bronze out of the case 7. The lead terminal 6a is electrically connected to the anode of the semiconductor luminous element 4 via the pattern 2a. Hereby, the lead terminal 6a is used for an anode (a positive electrode) as the light equipment 1 (1A) according to the invention.

The lead terminal 6b is electrically connected to the cathode of the semiconductor luminous element 4 via the pattern 2b. Hereby, the lead terminal 6b is used for a cathode (a negative electrode) as the light equipment 1 (1A) according to the invention.

The case 7 is molded in a concave form by mixing white powder such as barium titanate in insulating material such as a liquid crystal polymer made of transformed polyamide, polybutylene terephthalate or aromatic polyester. The pattern 2 is exposed at the bottom of the concave portion 7a of this case 7.

The case 7 efficiently reflects light from the side of the semiconductor luminous element 4 by white powder such as barium titanate excellent in the reflectivity of light and a light shielding property. The case 7 makes the reflected light emanating upward by a tapered concave face 7b of the concave portion 7a shown in FIG. 2. The case 7 shields light so that light emitted by the light equipment 1 (1A) according to the invention does not leak outside.

Further, as shown in FIG. 2, in the concave portion 7a of the case 7, a colorless and transparent protective layer 8 made of epoxy resin and others is filled to protect the pattern 2, the semiconductor luminous element 4, the wire 5 and others.

In the light equipment 1 (1A) configured as described above, the semiconductor luminous element 4 that emits blue light is used. For the transparent resin 3, resin in which wavelength converting material (or wavelength converting material and conductive material) made of orange fluorescent pigment or orange fluorescent dye is (are) mixed is used. Hereby, clear and high-luminance white light can be acquired.

That is, blue light is radiated from the upward of the semiconductor luminous element 4. And blue light radiated downward from the semiconductor luminous element 4 is converted to yellow light by the wavelength converting material of the transparent resin 3. The converted yellow light is radiated upward and downward the transparent resin 3. The yellow light radiated downward the transparent resin 3 is reflected on the surface of the pattern 2a under the transparent resin and is radiated upward. The blue light radiated by the semiconductor luminous element 4 itself and the yellow light converted by the wavelength converting material of the transparent resin 3 are mixed. And white light is radiated from the upward of the semiconductor luminous element 4.

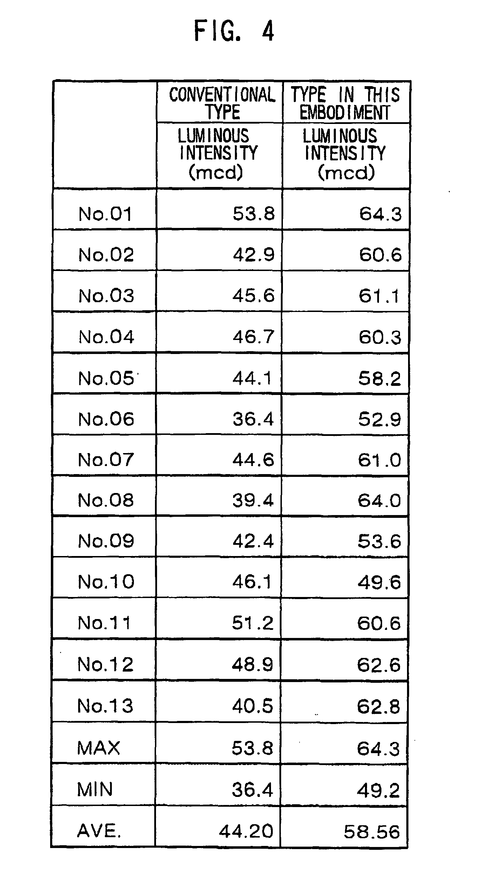

The luminous intensity measured in conventional type configuration that transparent resin in which fluorescent material is mixed is provided on a semiconductor luminous element and in the configuration according to the invention (the light equipment equivalent to the first embodiment) that the transparent resin in which the fluorescent material is mixed is bonded and fixed under the semiconductor luminous element or that the semiconductor luminous element is mounted (bonded) on the transparent resin in which the fluorescent material is mixed respectively of light equipment. In this case, the light equipments respectively installed in an element type (L1800) manufactured by this company under the following condition, and are compared. FIG. 4 shows a table including the result of the measurement.

Used chip: E1C10-1B001 (BL chip manufactured by Toyoda Gosei Co., Ltd.)
Used fluorescent material: YAG81004 (manufactured by NEMOTO & CO., LTD), Used resin: Epoxy resin (same material as conventional type and this embodiment)
Specification: Conventional type (Fluorescent material is provided on semiconductor luminous element), Type in this embodiment (Fluorescent material is provided under semiconductor luminous element)
Measurement condition: Luminous intensity when current per chip is 10 mA is measured
Measured number: Each 13 pieces
Measurement equipment: LED tester

As clear from the table shown in FIG. 4, it is known that in the configuration of the invention, the average luminous intensity is enhanced by approximately 32.5%, compared with that in the conventional type configuration.

### EMBODIMENT 2

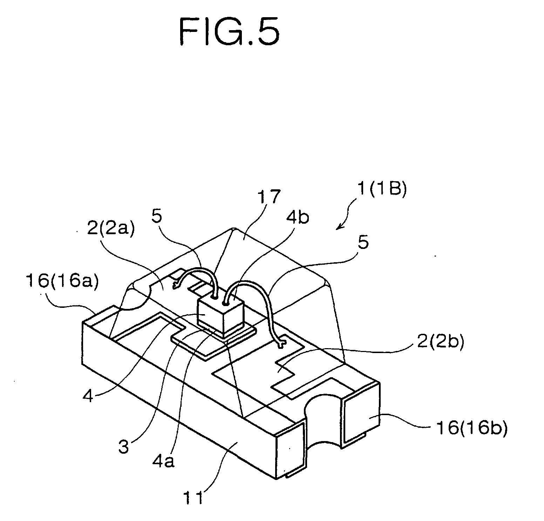

FIG. 5 is a general drawing showing a second embodiment of the light equipment according to the invention. The same number is allocated to the substantially similar component to that of the light equipment 1A equivalent to the first embodiment and the detailed description is omitted.

Light equipment 1B (1) equivalent to the second embodiment shown in FIG. 5 is a chip type. This light equipment 1B is composed of a board 11, a pattern 2 (2a, 2b), transparent resin 3, a semiconductor luminous element 4, wire 5, a terminal electrode 16 (16a, 16b) and the light emanating mold 17. The pattern 2 in this embodiment also includes an electric wiring pattern.

The board 11 is a board excellent in electric insulation, such as a ceramic board, a liquid crystal polymer resin board and a glass fiber epoxy resin board. The pattern 2 (2a, 2b) is formed on a surface of the board 11.

The board 11 made of a ceramic board for example is made of a compound having AlO or SiO as a principal component and further including ZrO, TiO, TiC, SiC or SiN. This ceramic board is excellent in heat resistance, hardness and strength, has a white surface and efficiently reflects light emitted from the semiconductor luminous element 4.

The board 11 made of liquid crystal polymer resin and glass fiber epoxy resin is formed by mixing or applying white powder such as barium titanate in/to insulating material such as a liquid crystal polymer and glass fiber epoxy resin. Therefore, light emitted from the semiconductor luminous element 4 is efficiently reflected.

For the board 11, pattern printing may be also applied to a laminated plate made of silicon resin, paper epoxy resin, synthetic fiber epoxy resin and paper phenol resin and a plate made of transformed polyimide, polybutylene terephthalate, polycarbonate and aromatic polyester so as to efficiently reflect light emitted from the semiconductor luminous element 4. In addition, metal such as aluminum may be also deposited and a film in which metal foil is laminated or sheet metal may be also stuck so as to provide a reflecting surface.

The pattern 2 (2a, 2b) is formed on the board 11 made of any of a ceramic, liquid crystal polymer resin and glass fiber epoxy resin by vacuum evaporation, sputtering, ion plating, chemical vapor deposition (CVD) and etching (wet etching, dry etching) in the shape of a pattern for electric connection. Further, after metal plating is applied to the surface of the pattern 2, the plating of noble metal such as gold and silver is further applied and the pattern is electrically connected to the terminal electrode 16 (16a, 16b).

The transparent resin 3 is provided between the pattern 2 on the board 11 and the back surface 4a (the surface without an electrode) of the semiconductor luminous element 4. As shown in an example shown in FIG. 5, the transparent resin 3 is provided in the substantially similar area to the area of the back surface 4a of the semiconductor luminous element 4. This transparent resin 3 also functions as an adhesive for sticking the semiconductor luminous element 4 to the pattern 2.

The semiconductor luminous element 4 has an anode and a cathode on one surface (the upper surface shown in FIG. 5: the front surface 4b). And the other surface without an electrode (the lower surface shown in FIG. 5: the back surface 4a) is stuck by the transparent resin 3. The anode and the cathode of the semiconductor luminous element 4 are respectively bonded to the patterns 2a and 2b by the wire 5.

The terminal electrode 16 (16a, 16b) is formed by thickly plating metal satisfactory in electric conduction on the end of the board 11 or mechanically attaching conductive and elastic phosphor bronze and others.

The terminal electrode 16a is electrically connected to the anode of the semiconductor luminous element 4 via the pattern 2a. Hereby, the terminal electrode 16a is used for an anode (a positive electrode) of the light equipment 1 (1B) according to the invention.

The terminal electrode 16b is electrically connected to the cathode of the semiconductor luminous element 4 via the pattern 2b. Hereby, the terminal electrode 16b is used for a cathode (a negative electrode) of the light equipment 1 (1B) according to the invention.

The light emanating mold 17 is molded in a rectangular shape by colorless and transparent epoxy resin. The light emanating mold 7 efficiently radiates light from a luminescent layer (the upper electrode side and four sides) of the semiconductor luminous element 4. The light emanating mold 17 protects the pattern 2, the semiconductor luminous element 4 and the wire 5.

Though the light emanating mold 17 is not shown, it can be formed in a free shape suitable for a purpose and a specification such as a dome for converging light in one direction.

In the light equipment 1 (1B) configured as described above, the semiconductor luminous element 4 that emits blue light is used. For the transparent resin 3, resin in which wavelength converting material (or wavelength converting material and conductive material) including orange fluorescent pigment or orange fluorescent dye is (are) mixed is used. Hereby, clear and high-luminance white light can be acquired.

That is, blue light is radiated from the upward of the semiconductor luminous element 4. And blue light radiated under the semiconductor luminous element 4 is converted to yellow light by the wavelength converting material of the transparent resin 3. The converted yellow light is radiated upward and downward the transparent resin 3. The yellow light radiated below the transparent resin 3 is reflected on the surface of the lead 2a under the transparent resin and is radiated upward. Blue light radiated by the semiconductor luminous element 4 itself and yellow light converted by the wavelength converting material of the transparent resin 3 are mixed. White light is radiated from the upward of the semiconductor luminous element 4.

### EMBODIMENT 3

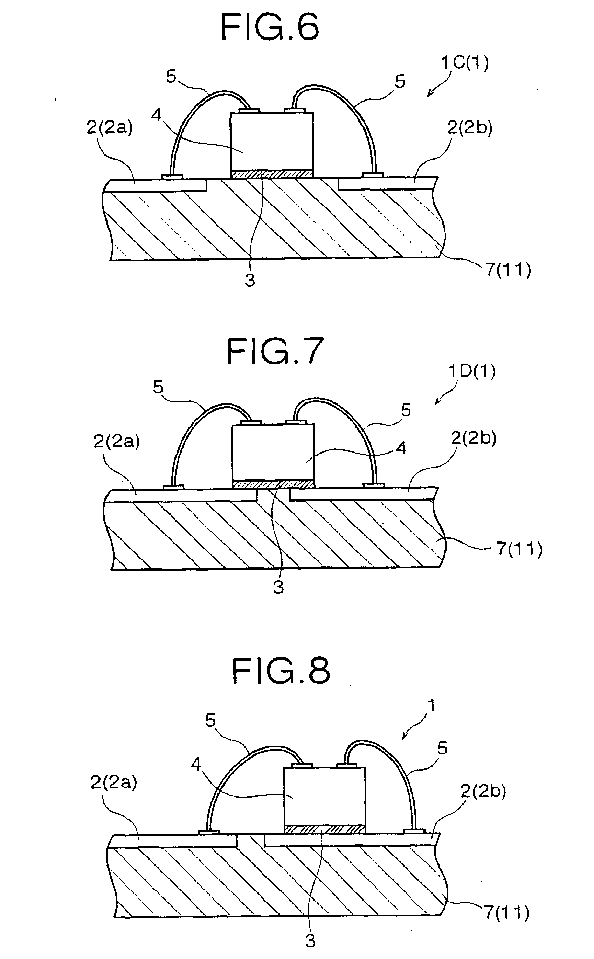

FIG. 6 is a partial sectional view showing a third embodiment of the light equipment according to the invention. The same number is allocated to the similar component to that of the light equipment 1A equivalent to the first embodiment and the light equipment 1B equivalent to the second embodiment and the detailed description is omitted.

In light equipment 1C (1) shown in FIG. 6, a semiconductor luminous element 4 is stuck on a part in which no pattern 2 (2a, 2b) on case 7 or a board 11 is formed via transparent resin 3. Concretely, the semiconductor luminous element 4 is stuck via the transparent resin 3 in a part (including an insulating pattern) between the pattern 2a and the pattern 2b respectively exposed at the bottom of a concave portion 7a of the case 7 or in a part (including an insulating pattern) between the patterns 2a and 2b on the board 11. The anode and the cathode of the semiconductor luminous element 4 are respectively bonded to the patterns 2a and 2b by wire 5.

### EMBODIMENT 4

FIG. 7 is a partial sectional view showing a fourth embodiment of the light equipment according to the invention. FIG. 8 is a partial sectional view showing a transformed example of the light equipment equivalent to the fourth embodiment. The same number is allocated to the similar component to that of the light equipment 1A equivalent to the first embodiment and the light equipment 1B equivalent to the second embodiment and the detailed description is omitted.

In light equipment 1D (1) shown in FIG. 7, a semiconductor luminous element 4 is stuck via transparent resin 3 across between patterns 2a and 2b respectively exposed at the bottom of a concave portion 7a inside of a case 7 or across between the patterns 2a and 2b on a board 11. The anode and the cathode of the semiconductor luminous element 4 are respectively bonded to the patterns 2a and 2b by wire 5. At that time, for the transparent resin 3, an insulating member in which wavelength converting material not including conductive material is mixed is used.

In case transparent resin in which conductive material and wavelength converting material are mixed is used, the transparent resin 3 is mounted so that it is in contact with only the negative pattern 2 as shown in FIG. 8, is grounded and the semiconductor luminous element 4 is stuck on the transparent resin 3.

### EMBODIMENT 5

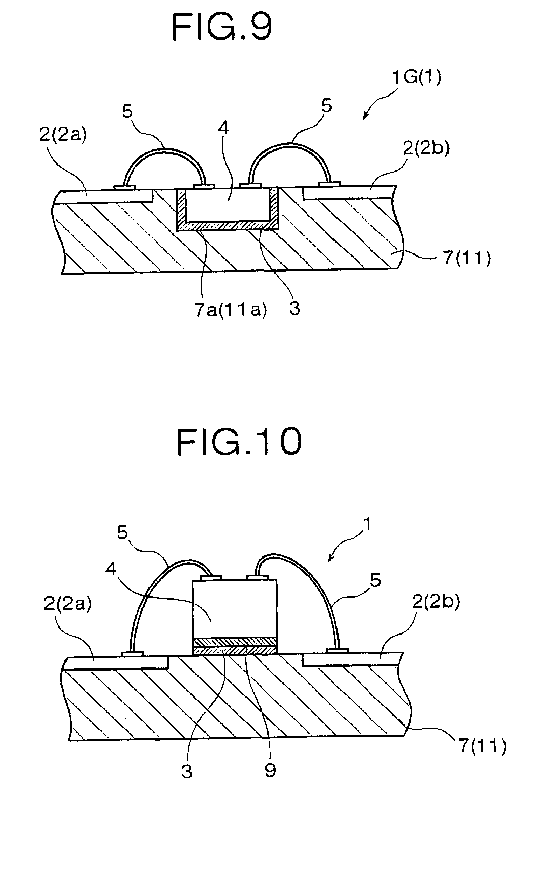

FIG. 9 is a partial sectional view showing a fifth embodiment of the light equipment according to the invention. The same number is allocated to the similar component to that of the light equipment 1A equivalent to the first embodiment and the light equipment 1B equivalent to the second embodiment and the detailed description is omitted.

In light equipment 1E (1) shown in FIG. 9, a semiconductor luminous element 4 is stuck via transparent resin 3 in a concave portion 7a formed in a part on a case 7 or a board 11 in which no pattern 2a, 2b is formed. Concretely, the semiconductor luminous element 4 is stuck via the transparent resin 3 in a concave portion 7a of the case 7 or at the bottom and on the peripheral surface of a concave portion 11a formed in the board 11.

The anode and the cathode of the semiconductor luminous element 4 are respectively bonded to the patterns 2a and 2b by wire 5. According to this configuration, after the wavelength of light radiated from the back surface and four sides of the semiconductor luminous element 4 is converted via the transparent resin 3, it is reflected in the concave portion 7a or in the concave portion 11a and is returned to the semiconductor luminous element 4 again. Light in which light the wavelength of which is converted and light from the semiconductor luminous element 4 itself are mixed is radiated from the front surface 4b of the semiconductor luminous element 4.

### EMBODIMENT 6

FIG. 10 is a partial sectional view showing a sixth embodiment of the light equipment according to the invention. The same number is allocated to the similar component to that of the light equipment 1A equivalent to the first embodiment and the light equipment 1B equivalent to the second embodiment and the detailed description is omitted.

Light equipment IF (1) shown in FIG. 10 is based upon the configuration of the light equipment 1E shown in FIG. 9 and only the lower surface of a semiconductor luminous element 4 is stuck via transparent resin 3 in a concave portion 7a of a case 7 or in a concave portion 11a of a board 11.

### EMBODIMENT 7

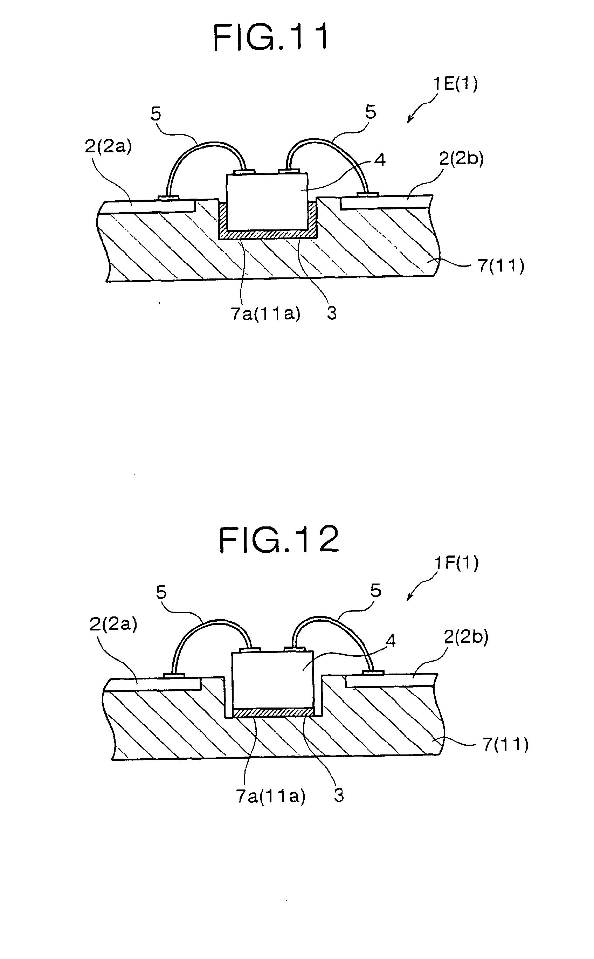

FIG. 11 is a partial sectional view showing a seventh embodiment of the light equipment according to the invention. The same number is allocated to the similar component to that of the light equipment 1A equivalent to the first embodiment and the light equipment 1B equivalent to the second embodiment and the detailed description is omitted.

Light equipment 1G (1) shown in FIG. 11 is based upon the configuration of the light equipment 1E shown in FIG. 9 and a semiconductor luminous element 4 is stuck via transparent resin 3 so that the whole is located in a concave portion 7a (or 11a) In the above-mentioned light equipment, the transparent resin 3 also functions as an adhesive. As shown in FIG. 12, a transparent adhesive 9 is applied on the transparent resin 3 and the semiconductor luminous element 4 may be also fixed on the transparent adhesive 9.

At that time, the used transparent adhesive is made of liquid cyanoacrylate the viscosity of which is low. Hereby, differently from an adhesive made of epoxy resin, the semiconductor luminous element 4 can be instantaneously bonded and fixed without heat and without having a bad effect upon the semiconductor luminous element 4. In addition, no heat is required for the adhesive to harden and as bonding speed is fast, the adhesive is advantageous in productivity and economy.

In FIG. 12, configuration in which the transparent adhesive 9 is used in the light equipment 1C equivalent to the third embodiment is shown, however, the configuration can be also applied to the light equipment equivalent to another embodiment described in relation to this embodiment.

In case transparent resin acquired by mixing wavelength converting material (wavelength converting material and conductive material) in a transparent adhesive made of cyanoacrylate the viscosity of which is high is used for the transparent resin 3, a printing process and a bonding process can be executed once.

In case the transparent resin 3 is formed by resin in which orange fluorescent pigment or orange fluorescent dye is mixed in the above-mentioned configuration shown in FIGs. 6 to 12 and a semiconductor luminous element that emits blue light is used for the semiconductor luminous element 4, light radiated downward the semiconductor luminous element 4 is converted to yellow light by wavelength converting material of the transparent resin 3. The yellow light is radiated to the semiconductor luminous element 4, is also radiated downward, the yellow light radiated downward is reflected in the lower part (in a case 7, on a board 11 and on the bonded surfaces of a pattern 2a and others and the transparent resin 3) and is returned to the semiconductor luminous element 4. Further, the yellow light is mixed with blue light radiated directly upward from the semiconductor luminous element 4. Hereby, white light can be radiated from the upper surface of the semiconductor luminous element 4.

### EMBODIMENT 8

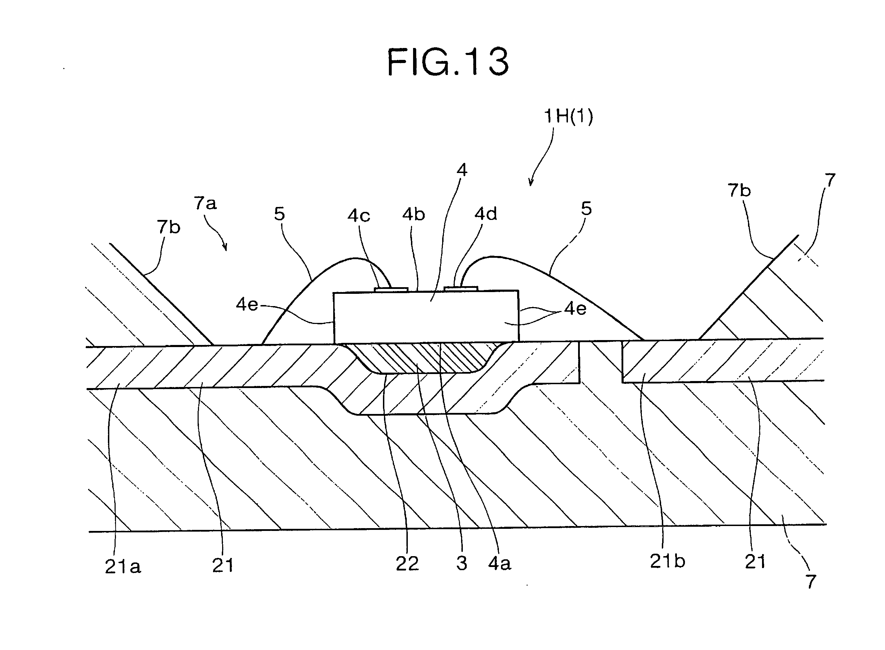

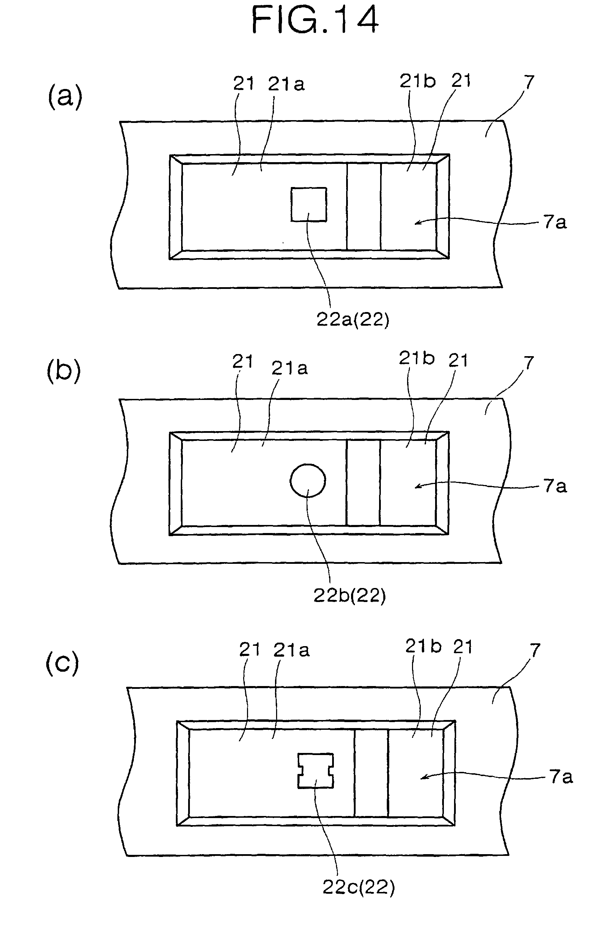

FIG. 13 is a partial sectional view showing an eighth embodiment of the light equipment according to the invention. FIGs. 14(a) to 14(c) are front views respectively showing a concave portion provided to a lead frame formed by injection molding or a board in light equipment equivalent to the eighth embodiment. The same number is allocated to the similar component to that of the light equipment 1A equivalent to the first embodiment and the light equipment 1B equivalent to the second embodiment and the detailed description is omitted.

Light equipment 1H (1) shown in FIG. 13 is provided with a lead frame 21, transparent resin 3, a semiconductor luminous element 4, wire 5 and a case 7. The lead frame 21 is formed by a metallic thin plate made of conductive and elastic aluminum and others. The lead frame 21 is formed by a punching press so that multiple units as one unit including plural mounting patterns 21a for mounting the semiconductor luminous element 4, a wiring pattern 21b for electrically connecting to the semiconductor luminous element 4, plural lead terminals not shown and a supporting frame not shown are arranged in parallel.

As shown in FIG. 13, in the mounting pattern 21a of the lead frame 21, a concave portion 22 smaller than the size of the back surface 4a of the semiconductor luminous element 4 is minutely formed in a position in which the semiconductor luminous element 4 is mounted. The concave portion 22 is formed by etching, laser beam machining or electrical discharge machining.

In case phosphor bronze slightly inferior in reflectivity is used for the lead frame 21, the plating of silver and others is applied to the lead frame to enhance reflection efficiency. The reason why reflection efficiency is enhanced is that the light emanating from the back surface 4a of the semiconductor luminous element 4 is reflected and is lead in the direction of the front surface 4b of the semiconductor luminous element 4 or upward outside the sides 4e of the semiconductor luminous element 4 again.

The mounting pattern 21a of the lead frame 21 is connected to the anode (or the cathode) of the semiconductor luminous element 4 via the wire 5. The wiring pattern 21b of the lead frame 21 is a pattern for electric connection without mounting the semiconductor luminous element 4. The wiring pattern 21b is connected to the cathode (or the anode) of the semiconductor luminous element 4 via the wire 5.

The lead frame 21 is formed by the insertion molding of the bottom face of the mounting pattern 21a and the wiring pattern 21b into the case 7 so that the patterns are insert symmetrically by a metallic mold not shown.

The lead frame 21 is provided with a supporting frame not shown formed by insertion molding. The lead frame 21 holds the whole frame till a process including the mounting and bonding of a chip such as the semiconductor luminous element 4, the bonding of the wire 5 and the filling of the transparent resin 3. For the lead frame 21, only the lead terminal not shown is finally left and the rest is cut and removed.

The concave 22 is minutely worked by etching, laser beam machining or electrical discharge machining and is formed so that it is smaller than the size of the back surface 4a of the semiconductor luminous element 4.

The concave portion 22 is respectively formed in a rectangular shape 22a shown in FIG. 14(a), in a circular shape 22b shown in FIG. 14(b) and in the shape of light emission 22c shown in FIG. 14(c) from the back surface 4a of the semiconductor luminous element 4. 14(c). The transparent resin 3 is filled in the concave portion 22 and the semiconductor luminous element 4 is mounted on the transparent resin 3.

As shown FIG. 13, a chip of the semiconductor luminous element 4 is mounted on the transparent resin 3 filled in the concave portion 22. The wire 5 bonds an electrode 4c and the mounting pattern 21a of the lead frame 21. The wire 5 bonds an electrode 4d and the wiring pattern 21b of the lead frame 21. Hereby, electric connection is made.

Particularly in case the shape of the electrode of the semiconductor luminous element 4 is arranged in the center of the right end and the left end of the chip, the transparent resin 3 is filled in the concave portion 22c shown in FIG. 14(c) and having the similar shape to the shape of light emission from the back surface 4a of the semiconductor luminous element 4. The semiconductor luminous element 4 is mounted on the transparent resin 3.

In case conductive transparent metal such as In₂O₃, SnO₂ and ITO is formed as electrodes (an anode and a cathode) 4c and 4d on the semiconductor luminous element 4 by a method such as sputtering, vacuum evaporation and chemical vapor deposition, light emanatings from the back surface 4a of the semiconductor luminous element 4 are in a substantially rectangular shape. In this case, the transparent resin 3 is filled in the concave portion 22a shown in FIG. 14(a) and the semiconductor luminous element 4 may be also mounted on it. The transparent resin 3 is filled in the circular concave portion 22b shown in FIG. 14(b) depending upon quantity productivity and workability and the semiconductor luminous element 4 may be also mounted on it.

The transparent resin 3 is filled in the concave portion 22 (22a, 22b, 22c) shown in FIGs. 14(a) to 14(c). The wavelength of the light emanating from the back surface 4a of the semiconductor luminous element 4 is converted. The light emanating the wavelength of which is converted is reflected in a metallic part of the concave portion 22. In the meantime, light radiated downward the semiconductor luminous element 4 is converted in color in the transparent resin 3. The light the color of which is converted is radiated upward the semiconductor luminous element 4 and is reflected in the lower part (by the case 7, the board 11 and the bonded surfaces of the pattern 2a and the transparent resin 3). The reflected light is also transmitted in the semiconductor luminous element 4 and is radiated upward the semiconductor luminous element 4. The radiated light is mixed with light directly radiated upward from the semiconductor luminous element 4.

For example, in case a semiconductor luminous element that emits blue light is used for the semiconductor luminous element 4 and rein in which wavelength converting material including orange fluorescent pigment or orange fluorescent dye is mixed is used for the transparent resin 3, blue light radiated downward the semiconductor luminous element 4 is converted to yellow light in the transparent resin 3. The converted yellow light is radiated upward the semiconductor luminous element 4. Simultaneously, after the yellow light is radiated downward the semiconductor luminous element 4, it is reflected at the bottom of the concave portion 22. The yellow light reflected in the concave portion 22 is also transmitted in the semiconductor luminous element 4 and is radiated upward the semiconductor luminous element 4. The yellow light directed to the semiconductor luminous element 4 and blue light directly radiated upward from the semiconductor luminous element 4 in these two processes are completely mixed. Therefore, uniform white light is radiated above the semiconductor luminous element 4. Hereby, clear and high-luminance white light can be acquired.

As the proper luminescent color transmitted in the epoxy resin in the transparent resin 3 of the semiconductor luminous element 4 and luminescent color acquired by converting the wavelength in the transparent resin 3 are mixed, a tonality shown in a chromaticity diagram and others can be acquired depending upon ratio in which colorless and transparent epoxy resin and silicone resin are mixed and dispersed.

For example, when light from the semiconductor luminous element 4 that emits blue light is projected onto the transparent resin 3 in which orange fluorescent pigment or orange fluorescent dye is mixed, white light is acquired by the mixture of the blue light and the orange light. In case the transparent resin 3 is included in large quantity, light in which an orange tone is deep is acquired. In case the transparent resin 3 is included in small quantity, light in which a blue tone is deep is acquired. However, when density distribution is large even if the transparent resin 3 is included by the same quantity, the quantity of light the wavelength of which is converted and which is returned to the semiconductor luminous element 4 again increases. Therefore, the most of light radiated from the semiconductor luminous element 4 is wavelength converted light from the surface of the transparent resin 3.

Then, in the light equipment 1H shown in FIG. 13, the concave portion 22 is provided, the quantity of the transparent resin 3 including wavelength converting material required for white light is maintained, and colorless and transparent epoxy resin and silicone resin are made to exist between particles of wavelength converting material of the transparent resin 3. Hereby, light the wavelength of which is converted in the transparent resin 3 reaches the bottom surface of the concave portion 22. The reflected light by the concave portion 22 passes between the particles of the wavelength converting material of the transparent resin 3. Therefore, reflection effect is prevented from being lost by returning the reflected light to the semiconductor luminous element 4 again.

The wire 5 electrically connects the anode 4c of the semiconductor luminous element and the mounting pattern 21a with the assistance of a bonder. Also, the wire 5 electrically connects the cathode 4d of the semiconductor luminous element 4 and the wiring pattern 21b with the assistance of a bonder.

Though now shown, the lead frame 21 (21a, 21b) is connected to a lead terminal made of a conductive and elastic copper alloy such as phosphor bronze or aluminum to pull out it outside. In another configuration, the lead frame may be pulled out of the case 7 encircling the whole as a lead terminal as it is.

Further, the case 7 shown in FIGs. 14(a) to 14(c) is formed by injection molding, inserting the lead frame 21 (21a, 21b) and others, pressing the case.

In the above-mentioned example, it is described that the concave portion 22 (22a, 22b, 22c) is formed in the lead frame 21 (21a, 21b), the transparent resin 3 including wavelength converting material is filled in the concave portion 22 and the semiconductor luminous element 4 is mounted on it. The board having a reflecting surface in a part in which the semiconductor luminous element 4 is mounted is also described. In this case, the concave portion 22 smaller than the size of the back surface 4a of the semiconductor luminous element 4 is provided to the board. The transparent resin 3 including wavelength converting material is filled in the concave portion 22. The semiconductor luminous element 4 is mounted on it.

However, in case the board is used in place of the lead frame 21, when the board is made of insulating material such as glass fiber epoxy resin for example after the concave portion 22 is formed in the board by etching, laser beam machining or electrical discharge machining, the plating of silver and others is applied to the concave portion 22 and the reflecting surface is formed. Hereby, reflection efficiency is enhanced.

An example of the light equipment 1H equivalent to the eighth embodiment will be described below.

(Y, Gd)₃(Al, Ga)₅O₁₂ : Ce is fluorescent pigment such as YAG. The ratio of the atomic weight of (Y, Gd)₃(Al, Ga)₅O₁₂ of (Y, Gd)₃(Al, Ga)₅O₁₂ : Ce and Ce of (Y, Gd)₃(Al, Ga)₅O₁₂ : Ce is variously changed. When this ratio was 1 : 4, wavelength converted material is further used. The wavelength converted material includes fluorescent pigment and epoxy resin. Average grain size of the fluorescent pigment is set to approximately 8 µm. The epoxy resin is colorless and transparent. The fluorescent pigment and the epoxy resin are respectively adjusted to 1 : 1 in ratio by weight and mixed. Hereby, white light could be acquired by orange luminescent color by the wavelength converted material and the luminescent color of the semiconductor luminous element that emits blue light.

In this example, higher average luminance was acquired in the case of the light equipment 1H wherein the concave portion 22 is provided to a position in this embodiment in which the semiconductor luminous element 4 is mounted and the transparent resin 3 is filled in the concave portion 22 by fixed quantity, compared with a case that the transparent resin 3 is applied to the semiconductor luminous element 4.

### EMBODIMENT 9

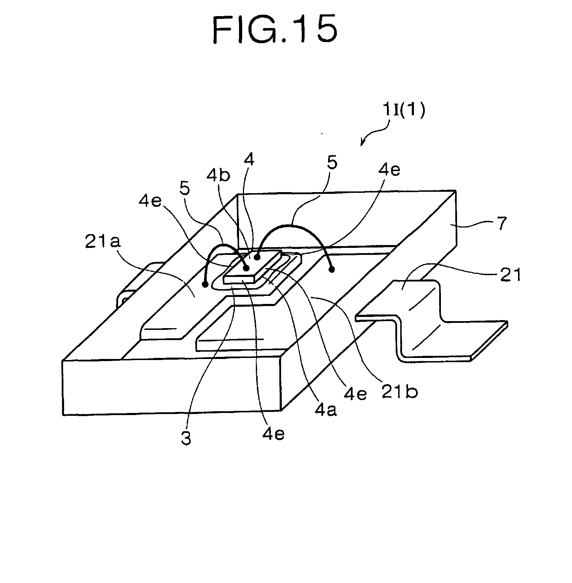

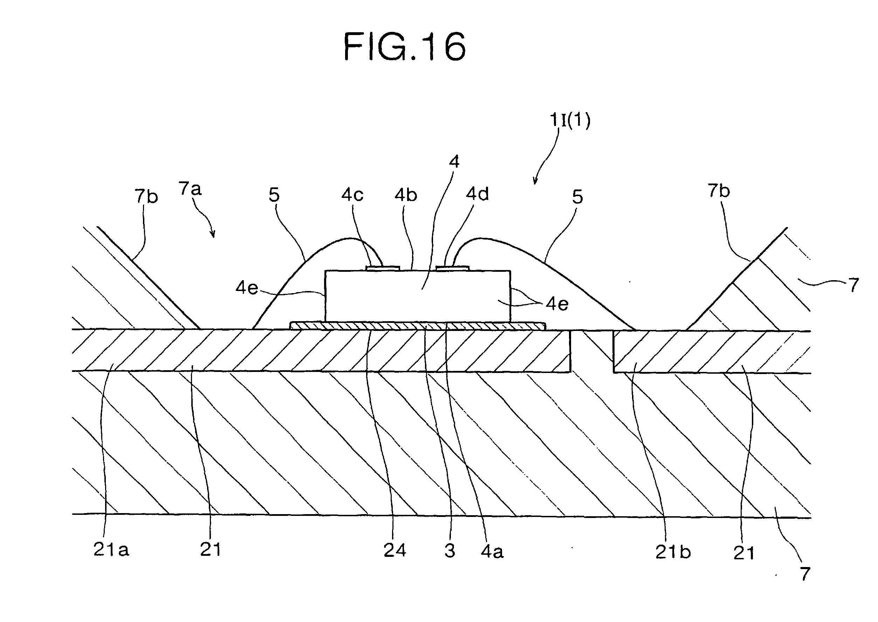

FIG. 15 is a schematic perspective view showing a ninth embodiment of the light equipment according to the invention. FIG. 16 is a partial side sectional view showing light equipment equivalent to the ninth embodiment. The same number is allocated to the similar component to that of the light equipment 1H equivalent to the eighth embodiment and the detailed description is omitted.

The light equipment 1I (1) equivalent to the ninth embodiment shown in FIGs. 15 and 16 is provided with a lead frame 21, transparent resin 3, a semiconductor luminous element 4 and a case 7.

The transparent resin 3 of the light equipment 1I is always kept fixed quantity by application or printing. The transparent resin 3 is provided in a large range around the outside of the semiconductor luminous element 4 having larger area than area 24 in which the semiconductor luminous element 4 is mounted. The large range in which resin3 is provided includes the area 24 on a wiring pattern 21a in which the semiconductor luminous element 4 is mounted (equivalent to the area of the back surface 4a of the semiconductor luminous element 4) on the lead frame 21 as shown in FIG. 15. Hereby, light radiated from the back surface 4a of the semiconductor luminous element 4 can be more efficiently converted in color. And even if the quantity of wavelength converting material by printing and others is small, an optimum tonality can be acquired.

The transparent resin 3 converts the wavelength of the light emanating from the back surface 4a of the semiconductor luminous element 4. The light the wavelength of which is converted is radiated toward the semiconductor luminous element 4 and is reflected in the lower part (on the bonded surfaces of the wiring pattern 21a and the transparent resin 3). The reflected light is also radiated upward the semiconductor luminous element 4. The reflected light is mixed with light directly radiated upward from the semiconductor luminous element 4.

For example, a semiconductor luminous element that emits blue light is used for the semiconductor luminous element 4. Resin in which wavelength converting material including orange fluorescent pigment or orange fluorescent dye is mixed is used for the transparent resin 3. Hereby, blue light radiated upward the semiconductor luminous element 4 is converted to yellow light in the transparent resin 3 by wavelength conversion.

The converted yellow light is radiated toward the semiconductor luminous element 4 located on the transparent resin 3. Simultaneously, the yellow light is reflected on the wiring pattern 21a of the lead frame 21. The yellow light reflected on the wiring pattern 21a of the lead frame 21 is also radiated upward the semiconductor luminous element 4. The yellow light directed to the semiconductor luminous element 4 and blue light directly radiated upward from the semiconductor luminous element 4 are completed mixed in these two processes. Therefore, uniform white light is radiated from the upside of the semiconductor luminous element 4. Hereby, clear and high-luminance white light can be acquired.

### EMBODIMENT 10

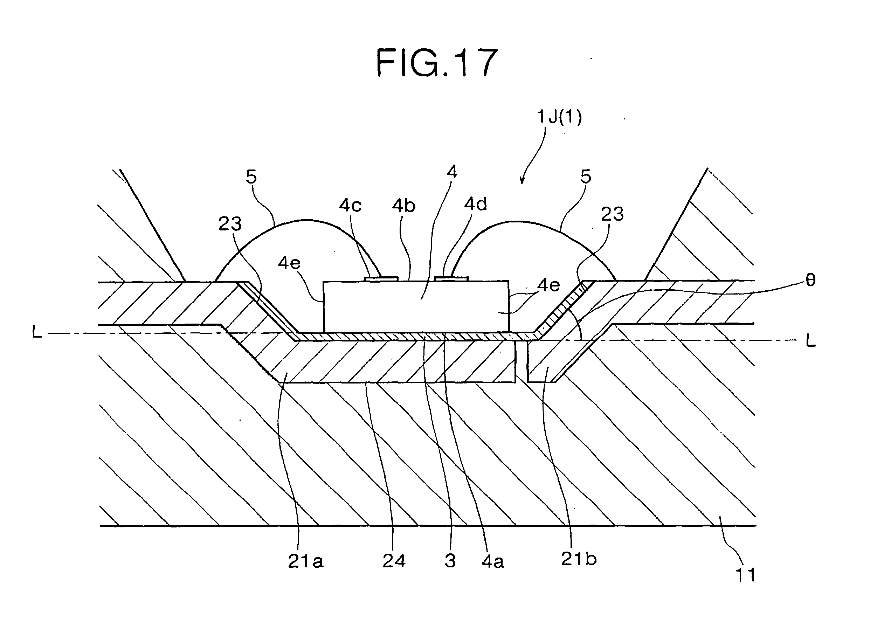

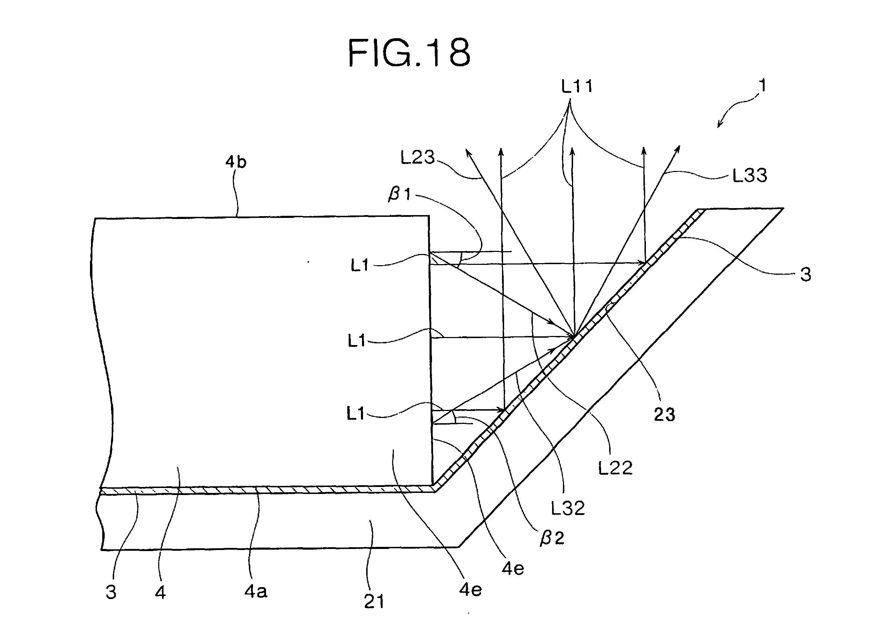

FIG. 17 is a partial sectional view showing a tenth embodiment of the light equipment according to the invention. FIG. 18 shows the locus of the light emanating on an inclined face from a semiconductor luminous element in light equipment equivalent to the tenth embodiment. The same number is allocated to the similar component to that of the light equipment 1H equivalent to the eighth embodiment and the detailed description is omitted.

The light equipment 1J (1) equivalent to the tenth embodiment shown in FIG. 17 is provided with a lead frame 21, transparent resin 3, a semiconductor luminous element 4 and a case 7 as in the light equipment 1I equivalent to the ninth embodiment.

The light equipment 1J (1) is different from the light equipment 1I in that an inclined face 23 is provided in a position on the lead frame 21 respectively opposite to four sides 4e of the semiconductor luminous element 4.

To explain further detailedly, the inclined face 23 is provided from the contour position of the back surface 4a of the semiconductor luminous element 4 shown in FIG. 18 or the outside of the contour position of the back surface 4a of the semiconductor luminous element 4 shown in FIG. 17 to the top so that the inclined face extends outside.

It is desirable that an angle *θ* between the inclined face 23 and a virtual extended line (an L-L line shown by an alternate long and short dash line in FIG. 17) of the back surface 4a from the contour position of the back surface 4a of the semiconductor luminous element 4 is larger than 0° and is equal to/smaller than 45° and the inclined face extends outside and upward. In FIGs. 17 and 18, the inclination *θ* of the inclined face 23 is 45° . Hereby, the light emanating from four sides 4e of the semiconductor luminous element 4 can be efficiently reflected upward.

The transparent resin 3 is always kept fixed quantity by application or printing. The transparent resin 3 is provided up to a position on the inclined face 23 opposite to the side 4e of the semiconductor luminous element 4 in a large range having larger area than the size of the semiconductor luminous element 4. The large range includes the area 24 in which the semiconductor luminous element 4 is mounted on the lead frame 21 as shown in FIG. 17. Hereby, light radiated from the semiconductor luminous element 4 can be more efficiently converted in color. And even if the quantity of wavelength converting material by printing and others is small, an optimum tonality can be acquired.

Referring to FIGs. 16 and 17, the locus of light will be described below.

The wavelength of light radiated downward from the back surface 4a of the semiconductor luminous element 4 is converted by the wavelength converting material of the transparent resin 3. A part of the converted light is radiated toward the semiconductor luminous element 4. The other converted light is reflected on the wiring pattern 21a of the lead frame 21. The reflected light is also radiated toward the semiconductor luminous element 4. This light is transmitted in the semiconductor luminous element 4 and is mixed with light directly radiated upward from the semiconductor luminous element 4.

The wavelength of light L22 that goes downward out of light emanating from the four sides 4e of the semiconductor luminous element 4 is converted by wavelength converting material included in the transparent resin 3 provided on the inclined face 23. The light L22 is reflected at an angle of reflection equal to each angle of incidence from four sides 4e of the semiconductor luminous element 4. This light is mixed with light L1 respectively outgoing in a horizontal direction from the four sides 4e of the semiconductor luminous element 4 and light L11 that goes upward.

In the case of the light equipment 1J in which the inclined face 23 is provided, the light L1 that goes at right angles to the sides 4e is reflected at an angle of 45° on the inclined face 23 having the inclination of 45° as shown in FIG. 18. The reflected light L11 goes vertically upward (at right angles to a virtual face parallel to the front surface 4b).

As shown in FIG. 18, differently from light L1 outgoing from the sides 4e for example, the wavelength of light L22 which is made outgoing downward and the angle β1 of outgoing radiation of which is approximately 30° is converted by the wavelength converting material of the transparent resin 3 on the inclined face 23 having the inclination of 45° . And the light is reflected. The converted and reflected light L23 is outgoing upward slightly near to the semiconductor luminous element 4.

Similarly, differently from light L1 outgoing from the sides 4e, the wavelength of light L32 which is made outgoing upward and the angle β of outgoing radiation of which is approximately 30° is converted by the wavelength converting material of the transparent resin 3 on the inclined face 23 having the inclination of 45° and the light is reflected. The converted and reflected light L33 is outgoing above the semiconductor luminous element 4 slightly apart from the semiconductor luminous element 4.

Therefore, the quantity of most light L1 and L32 except light that goes downward from the sides 4e is equivalent to approximately 84% of the quantity of all light outgoing from the sides 4e. Therefore, the light emanating made a good show in a tonality and luminance can be acquired by using the light emanating utilizing light from the four sides 4e.

As described above, the wavelength of light outgoing from the four sides 4e of the semiconductor luminous element 4 is converted by the wavelength converting material of the transparent resin 3 provided on the inclined face 23 of the lead frame 21 corresponding to the position of the four sides 4e of the semiconductor luminous element 4. Afterward, the light is reflected vertically upward by the inclined face 23. The reflected light is mixed with direct light from the semiconductor luminous element 4 and reflected light reflected on the inclined face 23 without being converted in a wavelength. The reflected light is radiated outside from the upside of the semiconductor luminous element 4 as mixed color (for example, white light).

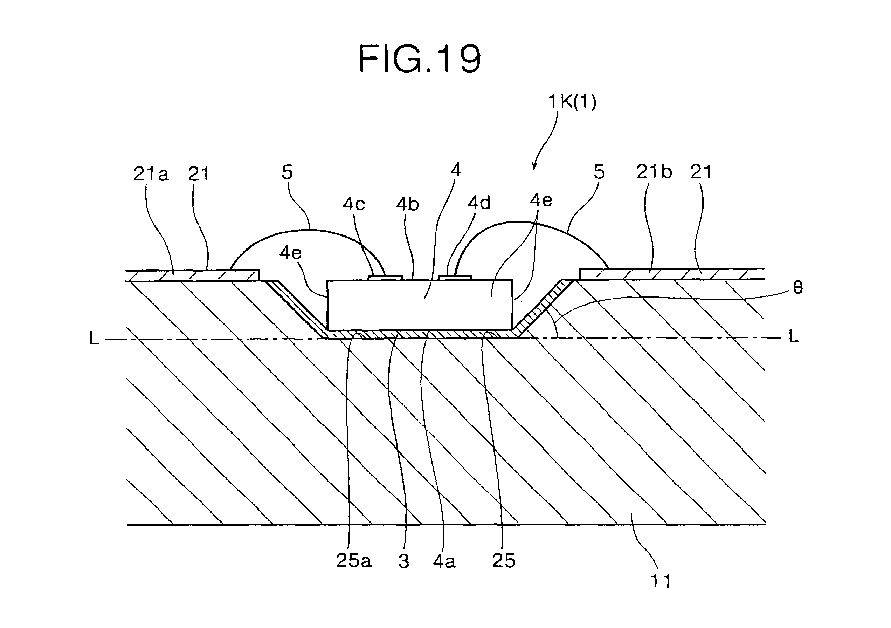

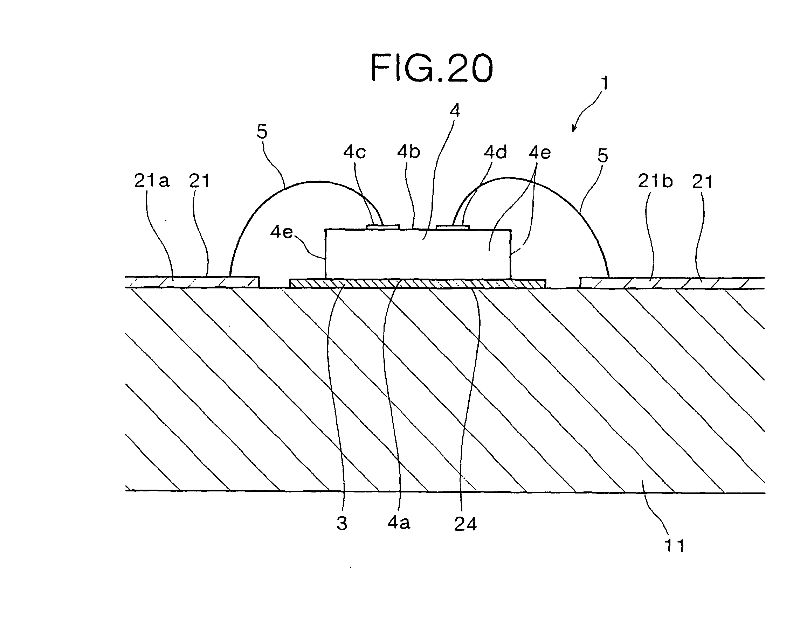

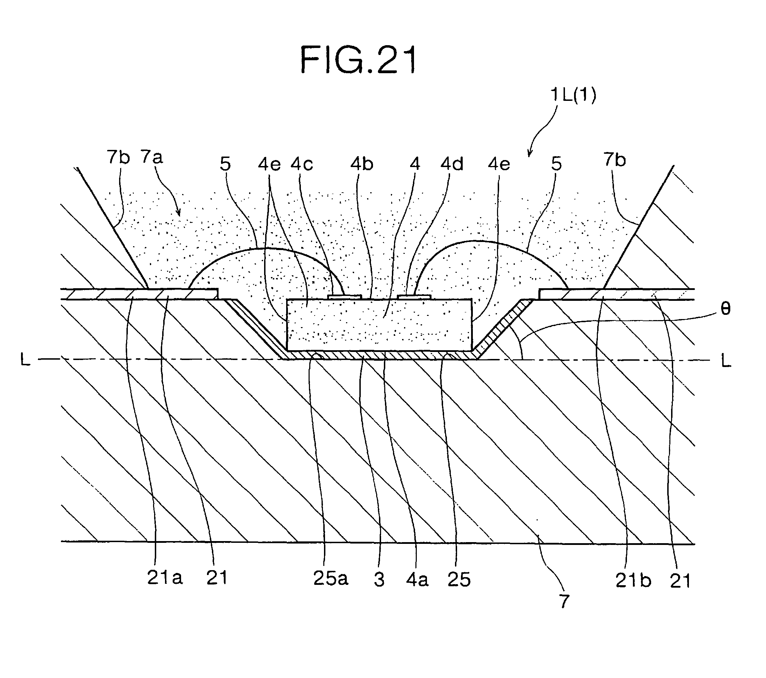

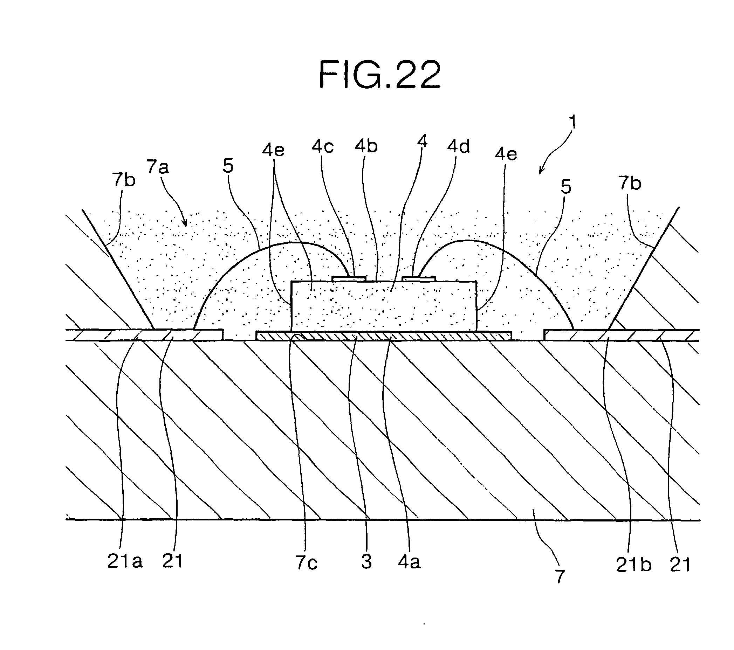

In FIGs. 15 to 18, the configuration is described so that the transparent resin 13 is provided in larger area than the area 24 in which the semiconductor luminous element 4 is mounted on the lead frame 21. However, in place of the lead frame 21 as base material on which the transparent resin 3 is provided, a board 11 shown in FIGs. 19 and 20 and a case 7 shown in FIGs. 21 and 22 may be also used.

### EMBODIMENT 11

FIG. 19 is a partial sectional view showing an eleventh embodiment of the light equipment according to the invention. The same number is allocated to the substantially similar component to that of the light equipment 1J equivalent to the tenth embodiment and the detailed description is omitted.

In light equipment 1K (1) shown in FIG. 19, a rectangular concave portion 25 is formed on the surface of a board 11. The bottom of the concave portion 25 forms a smooth surface 24 on which a semiconductor luminous element 4 is mounted. This surface 24 has the similar or larger area to than the area of the back surface 4a of the semiconductor luminous element 4. The peripheral wall of the concave portion 25 is opposite to four sides 4e of the semiconductor luminous element 4 and forms the similar inclined face 23 to that of the light equipment 1J equivalent to the tenth embodiment.

Transparent resin 3 is formed in the concave portion 25 on the board 11 by application or printing and is always kept fixed quantity. The area of the transparent resin 3 is larger than the area of the back surface 4a of the semiconductor luminous element 4 as shown in FIG. 19. The back surface 4a of the semiconductor luminous element 4 is bonded on a flat surface 25a of the concave portion 25 via the transparent resin 3 so as to be included in the transparent resin 3.

The above-mentioned light equipment 1K may also have configuration that no concave portion 25 is formed in the board 11 as shown in FIG. 20. In this case, the transparent resin 3 is provided on the board 11. The area of the transparent resin 3 is larger than the area of the back surface 4a of the semiconductor luminous element 4. The back surface 4a of the semiconductor luminous element 4 is bonded on the board 11 via the transparent resin 3 so as to be included in the transparent resin 3.

### EMBODIMENT 12

FIG. 21 is a partial sectional view showing a twelfth embodiment of the light equipment according to the invention. The same number is allocated to the substantially similar component to that of the light equipment 1J equivalent to the tenth embodiment and the detailed description is omitted.

In light equipment 1L (1) shown in FIG. 21, a rectangular concave portion 25 is formed at the bottom of a concave portion 7a of a case 7. The bottom of the concave portion 25 forms a smooth surface 24 on which a semiconductor luminous element 4 is mounted. This surface 24 has the similar or larger area to/than the area of the back surface 4a of the semiconductor luminous element 4. The peripheral wall of the concave portion 25 is opposite to four sides 4e of the semiconductor luminous element 4 and forms the similar inclined face 23 to that of the light equipment 1J equivalent to the tenth embodiment.

Transparent resin 3 is formed on the concave portion 25 of the case 7 by application or printing and is always kept fixed quantity. The area of the transparent resin 3 is larger than the area of the back surface 4a of the semiconductor luminous element 4 as shown in FIG. 21. The back surface 4a of the semiconductor luminous element 4 is bonded on a flat surface 25a of the concave portion 25 via the transparent resin so that the back surface 4a is included in the transparent resin 3.

The above-mentioned light equipment 1L may also have configuration that no concave portion 25 is formed in a concave portion 7a of a case 7 as shown in FIG. 22. In this case, the transparent resin 3 is provided on a flat surface 7c of the concave portion 7a of the case 7. The area of the transparent resin 3 is larger than the area of the back surface 4a of the semiconductor luminous element 4. The back surface 4a of the semiconductor luminous element 4 is bonded on the flat surface 7c of the case 7 via the transparent resin 3 so as to be included in the transparent resin 3.

As described above, in the light equipment 1 equivalent to this embodiment, the semiconductor luminous element 4 is bonded and fixed by the transparent resin 3 in which wavelength converting material (or wavelength converting material and conductive material) is (are) mixed on base material having reflectivity (a reflective board 11, a reflective lead frame 21, a reflective pattern and a reflective electric wiring pattern in the case 7). Hereby, the wavelength of light outgoing from the surface (the back surface 4a, the side 4e) except the front surface 4b of the semiconductor luminous element 4 is converted by the wavelength converting material (or the wavelength converting material and the conductive material) of the transparent resin 3. The converted light is transmitted in the semiconductor luminous element 4 again and is outgoing from the front surface 4b as mixed light.

To acquire white light, a semiconductor luminous element that emits blue light is used for the semiconductor luminous element 4. For the transparent resin 3, resin in which wavelength converting material (or wavelength converting material and conductive material) including orange fluorescent pigment or orange fluorescent dye is (are) mixed is used. Hereby, blue light from the semiconductor luminous element 4 itself is radiated upward the semiconductor luminous element 4. Blue light radiated downwaard the semiconductor luminous element 4 is reflected toward the semiconductor luminous element 4 again as yellow light converted by the wavelength converting material of the transparent resin 3. Further, blue light radiated upward the semiconductor luminous element 4 and yellow light reflected toward the semiconductor luminous element 4 are completely mixed and uniform white light is radiated from the upside of the semiconductor luminous element 4. As a result, if wavelength converting material (a color converting member) is evenly distributed, clearer and higher-luminance white light can be acquired.

Particularly, as shown in FIGs. 17 and 18, according to the light equipment provided with the inclined face 23 opposite to the four sides 4e of the semiconductor luminous element 4, the wavelength of most of light emanatings from the back surface 4a of the semiconductor luminous element 4 and light emanatings from the four sides 4e of the semiconductor luminous element 4 is converted by the wavelength converting material of the transparent resin 3 formed between the back surface 4a of the semiconductor luminous element 4 and the inclined face 23. The most are reflected toward the semiconductor luminous element 4. As a blue light emanating from the front surface 4b of the semiconductor luminous element 4 and yellow reflected light outgoing from the back surface 4a and the side 4e and converted in a wavelength are mixed, white light can be acquired. Hereby, the light equipment excellent in a color tone and satisfactory in lightening, economy and downsizing can be acquired.

As described above, the light equipment according to the invention is used for a light source for a lamp and a display. The light equipment is useful for a light source for a liquid crystal display, a mobile telephone, portable terminal equipment, small-sized terminal equipment and others.

## Claims

1. Light equipment, comprising:
transparent resin which is provided on the reflecting surface of base material and in which wavelength converting material is mixed; and
a transparent semiconductor luminous element provided on the transparent resin, wherein:
the wavelength of light emitted from the back surface of the semiconductor luminous element is converted by the wavelength converting material;
the converted light is reflected on the reflecting surface; and
the reflected light and light directly emitted from the front surface of the semiconductor luminous element are mixed and the mixed light is radiated from the surface of the semiconductor luminous element.

2. Light equipment according to Claim 1, wherein:
conductive material is further mixed in the transparent resin.

3. Light equipment according to Claim 1, wherein:
the transparent resin is formed in larger area than the area of the semiconductor luminous element on the base material; and
the semiconductor luminous element is bonded and fixed on the transparent resin on the base material.

4. Light equipment according to Claim 1, wherein:
a concave portion is provided to the base material;
the transparent resin is filled in the concave portion; and
the semiconductor luminous element is bonded and fixed on the transparent resin filled in the concave portion.

5. Light equipment according to Claim 4, wherein:
the aperture area of the concave portion is smaller than the area of the back surface of the semiconductor luminous element.

6. Light equipment according to Claim 4, wherein:
the inner wall of the concave portion is opposite to the side of the semiconductor luminous element; and
the inner wall is an inclined face that extends from the bottom of the concave portion toward the aperture of the concave portion.

7. Light equipment according to Claim 6, wherein:
an angle between the inclined face of the concave portion and the bottom of the concave portion is larger than 0° and is equal to or smaller than 45° .

8. Light equipment according to Claim 4, wherein:
the aperture of the concave portion is in the shape of light emission of the semiconductor luminous element, in a rectangular shape or in a circular shape.

9. Light equipment according to Claim 4, wherein:
the concave portion is processed and formed by etching, laser beam machining or electrical discharge machining.

10. Light equipment according to Claims 1, wherein:
the semiconductor luminous element is bonded and fixed on the transparent resin by a transparent adhesive.

11. Light equipment according to Claim 10, wherein:
the semiconductor luminous element is provided with a transparent electrode on the back surface; and
the transparent electrode is provided on an active layer formed on a transparent board.

12. Light equipment according to Claims 1, wherein:
the base material is made of any of a ceramic board, a liquid crystal polymer resin board, a glass fiber epoxy resin board, a lead frame and a reflective case.

13. Light equipment according to Claims 1, wherein:
the semiconductor luminous element is made of any of InGaAlP, InGaAlN, InGaN and GaN.
